# EUROPÄISCHE PATENTSCHRIFT

(11) **EP 2 246 866 B1**
(45) Veröffentlichungstag und Bekanntmachung des Hinweises auf die Patenterteilung: **25.10.2017**
(21) Anmeldenummer: 10173301.2
(22) Anmeldetag: 03.12.2004
(51) Int. Cl.: H01G 4/40, H01C 13/02, H03H 7/01

(54) **Elektrisches Bauelement und Schaltungsanordnung**
Electric component and circuit arrangement
Composant électrique et agencement de circuit

(30) Priorität: 03.12.2003 DE 10356498
(43) Veröffentlichungstag der Anmeldung: 03.11.2010
(62) Teilanmeldung aus: 04028710.4
(73) Patentinhaber: EPCOS AG, 81669 München (DE)
(72) Erfinder: Feichtinger, Thomas, 8010, Graz (AT); Pürstinger, Thomas, 8020, Graz (AT)
(74) Vertreter: Epping - Hermann - Fischer

(56) Entgegenhaltungen:
- EP-A2- 1 369 880
- DE-A1- 10 064 447
- DE-A1- 10 144 364
- JP-A- 8 124 800
- JP-A- 2000 058 382
- JP-A- 2000 124 068
- US-A- 5 815 367

## Beschreibung

Die Erfindung betrifft ein elektrisches Bauelement mit einem Grundkörper, der eine Abfolge von übereinandergestapelten keramischen Schichten umfaßt und mehrere zwischen den keramischen Schichten angeordnete Innenelektroden enthält.

Aus der Druckschrift JP 10097954 A ist ein elektrisches Bauelement der eingangs genannten Art bekannt, bei dem zusätzlich zu den Innenelektroden auch Widerstandsstrukturen vorhanden sind, die eine interne Verschaltung bewirken können.

Die Druckschrift DE 10064447 A1 offenbart ein elektrisches Vielschichtbauelement, das einen Grundkörper umfasst, der miteinander verstapelte Elektrodenschichten einer ersten und einer zweite Sorte aufweist. Die Elektrodenschichten sind durch Dielektrikumschichten voneinander getrennt und bilden mindestens eine Kapazität. Auf Seitenflächen des Grundkörpers sind zwei Paare von Außenkontakten angeordnet, wobei die direkten Verbindungen der jeweils zu einem Paar gehörenden Außenkontakte einander überkreuzen. Des Weiteren ist das erste Paar von Außenkontakten mit den Elektrodenschichten der ersten Sorte und das zweite Paar von Außenkontakten mit den Elektrodenschichten der zweiten Sorte kontaktiert.

Die Erfinder haben überraschenderweise gefunden, daß diese Bauelemente in Abhängigkeit von ihrer Lageposition auf einer Leiterplatte unterschiedliche elektrische Eigenschaften, z.B. unterschiedliche Filtercharakteristiken aufweisen können.

Ziel der vorliegenden Erfindung ist es daher, ein elektrisches Bauelement anzugeben, das gegenüber dem oben genannten Nachteil verbessert ist.

Dieses Ziel wird beispielsweise durch ein elektrisches Bauelement gemäß Anspruch 1 erreicht. Bei einem derartigen erfindungsgemäßen Bauelement ist aufgrund der besonders hohen Symmetrie der Einfluß der Positionierung des Bauteils auf die elektrischen Eigenschaften in einer äußeren Schaltungsumgebung, z.B. auf einer Platine, gegenüber herkömmlichen Bauelementen verringert.

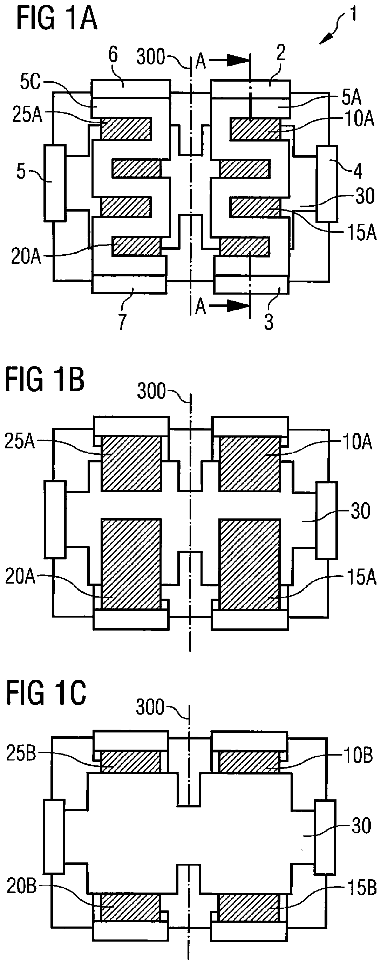

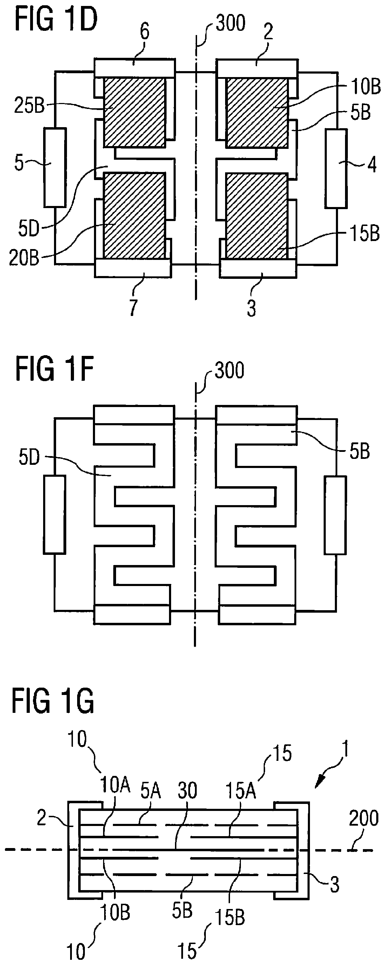

In einer vorteilhaften Ausführungsform überlappt bei einem erfindungsgemäßen elektrischen Bauelement zumindest eine Innenelektrode mit den Innenelektroden von wenigstens zwei weiteren Elektrodenstapeln. Eine derartige Ausführungsform hat den Vorteil, daß auf sehr kleinem Volumen viele miteinander überlappende Elektrodenstapel gebildet werden können, so daß eine hohe Integrationsdichte von elektrischen Strukturen im Bauelement resultiert. Die wenigstens eine Innenelektrode, die mit wenigstens zwei weiteren Elektrodenstapeln überlappt, kann beispielsweise über eine auf der Oberfläche des Grundkörpers angeordnete Kontaktfläche kontaktiert werden und als Masseanschluß für zwei Elektrodenstapel dienen, so daß zwei Vielschichtkondensatoren mit einem gemeinsamen Masseanschluß resultieren (siehe beispielsweise Figur 1G). Die zumindest eine Innenelektrode kann aber auch mit mehr als zwei Elektrodenstapeln überlappen. Die zumindest eine Innenelektrode kann aber auch Teil eines Elektrodenstapels sein, mit der Folge, daß dann ein Elektrodenstapel mit zumindest zwei anderen Elektrodenstapeln überlappt.

Weiterhin ist es möglich, daß die wenigstens eine Verschaltungsstruktur als strukturierte Schicht auf den keramischen Schichten ausgebildet ist. Eine derartige Ausführungsform hat den Vorteil, daß die Verschaltungsstrukturen z.B. mittels Siebdruck besonders einfach auf den keramischen Schichten erzeugt werden können. Die Verschaltungsstrukturen können dabei aus leitfähigen Pasten erzeugt werden. Die Verschaltungsstrukturen können dabei ähnlich wie die Innenelektroden Silber, Palladium, Platin, Kupfer, Nickel oder eine Legierung aus Silber und Palladium oder aus Silber und Platin enthalten. Aus derartigen Metallen bzw. Metallegierungen hergestellte Verschaltungsstrukturen ermöglichen niederohmige Verschaltungen. Zur Generierung von hochohmigen Verschaltungsstrukturen ist es beispielsweise auch möglich, daß die Verschaltungsstrukturen RuO₂, Bi₂Ru₂O₇, C, Ti₂N oder LaB₆ enthalten.

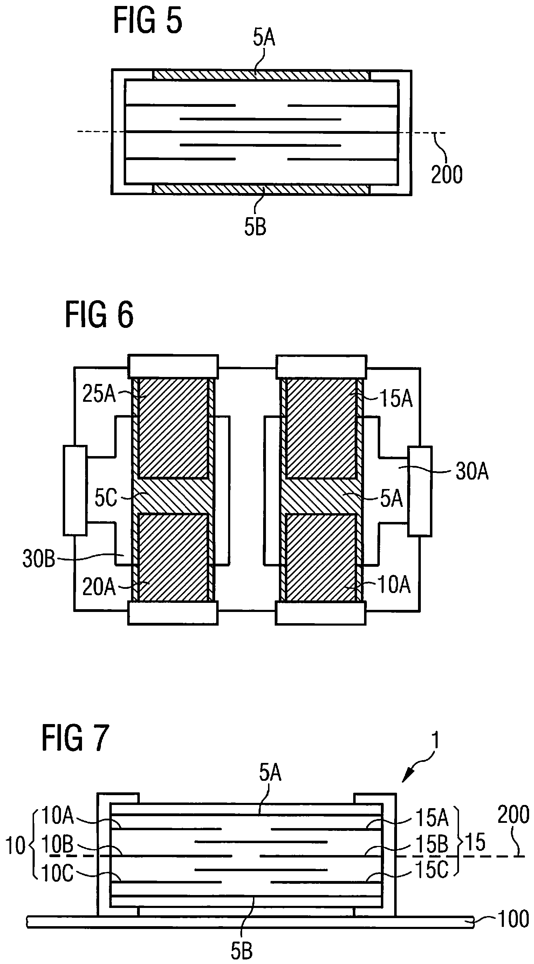

Vorteilhafterweise kann dabei die zumindest eine Verschaltungsstruktur im Inneren des Grundkörpers zwischen unterschiedlichen Paaren von keramischen Schichten angeordnet sein. Eine derartige Ausführungsform ist z.B. in Figur 1G gezeigt. Möglich ist es aber auch, daß im Falle von zwei Verschaltungsstrukturen diese auf sich gegenüberliegenden Oberflächen des Grundkörpers angeordnet sind, wie z.B. in Figur 5 gezeigt.

Günstigerweise sind im Fall von wenigstens zwei Verschaltungsstrukturen diese so im oder auf dem Grundkörper angeordnet, daß die Innenelektroden derjenigen Elektrodenstapel, die durch die Verschaltungsstrukturen verbunden sind, zwischen den beiden Verschaltungsstrukturen im Grundkörper angeordnet sind. Eine derartige Anordnung von Verschaltungsstrukturen und Innenelektroden ist beispielsweise in den Figuren 1G und 5 gezeigt. In diesem Fall schirmen die vorteilhafterweise oberhalb bzw. unterhalb der Innenelektroden angeordneten Verschaltungsstrukturen die Innenelektroden gegenüber einer Platine, auf die das Bauelement montiert wird, besonders gut ab, so daß erneut eine Reduzierung des Einflusses der Positionierung des Bauelements auf die elektrischen Eigenschaften resultiert.

In einer weiteren Variante des erfindungsgemäßen Bauelements ist eine erste Verschaltungsstruktur zwischen zwei im oberen Bereich des Grundkörpers und eine zweite Verschaltungsstruktur zwischen zwei im unteren Bereich des Grundkörpers befindlichen keramischen Schichten angeordnet, wobei diese erste und zweite Verschaltungsstruktur zwei im Grundkörper gegenüberliegende Elektrodenstapel miteinander verbinden. Die zwei Elektrodenstapel überlappen dabei mit einem dritten Elektrodenstapel, wobei die Innenelektroden der zwei Elektrodenstapel, die durch die Verschaltungsstrukturen verbunden sind, zwischen der ersten und zweiten Verschaltungsstruktur im Grundkörper angeordnet sind. Eine derartige relative Anordnung der Verschaltungsstrukturen und Innenelektroden erlaubt eine besonders hohe Integrationsdichte von elektrischen Strukturen im erfindungsgemäßen elektrischen Bauelement, wobei gleichzeitig eine besonders geringe Abhängigkeit der elektrischen Eigenschaften des Bauelements von seiner Lage auf der Platine erreicht werden kann.

Vorteilhafterweise sind die Verschaltungsstrukturen so ausgeformt, daß sie von oben oder von unten auf den Grundkörper aus übereinandergestapelten Schichten betrachtet zumindest den Bereich abdecken, in dem die zwei Elektrodenstapel mit dem dritten Elektrodenstapel überlappen. Eine Aufsicht auf eine derart ausgestaltete Verschaltungsstruktur ist beispielsweise in der Figur 6 gezeigt. In dem Fall, daß in der Aufsicht auf die Verschaltungsstrukturen der Überlappungsbereich zwischen den Elektrodenstapeln abgedeckt ist, resultiert eine besonders gute Abschirmung der Innenelektroden gegenüber der Platine, auf der das Bauelement montiert werden kann. Derartige Bauelemente weisen daher einen besonders geringen Einfluß ihrer Lageposition auf der Platine auf die elektrischen Eigenschaften auf.

In einer weiteren Variante eines erfindungsgemäßen Bauelements überlappen ein erster und ein zweiter Elektrodenstapel mit einem dritten Elektrodenstapel, wobei die Innenelektroden des ersten und zweiten Elektrodenstapels zwischen zwei Innenelektroden des dritten Elektrodenstapels im Grundkörper angeordnet sind. Bei einem derartigen Bauelement ergibt sich ein zusätzlicher Abschirmeffekt für die Innenelektroden des ersten und zweiten Elektrodenstapels dadurch, daß sie zwischen zwei Innenelektroden des dritten Elektrodenstapels angeordnet sind.

Der Grundkörper eines erfindungsgemäßen elektrischen Bauelements kann entlang einer Längsrichtung verlaufende Seitenflächen und mindestens eine Stirnfläche aufweisen, wobei dann durch zwei überlappende Elektrodenstapel ein Vielschichtkondensator gebildet ist und die Kontaktfläche eines überlappenden Elektrodenstapels des Vielschichtkondensators auf einer Seitenfläche und die Kontaktfläche des anderen überlappenden Elektrodenstapels des Vielschichtkondensators auf der Stirnfläche des Grundkörpers angeordnet ist. Eine derartige Anordnung von Kontaktflächen für die Elektrodenstapel auf der Oberfläche des Grundkörpers ist besonders vorteilhaft und ermöglicht eine besonders hohe Dichte von Kontaktflächen auf dem Grundkörper, wobei dann auch besonders einfach eine hohe Integrationsdichte von Elektrodenstapeln im Grundkörper von erfindungsgemäßen Bauelementen verwirklicht werden kann.

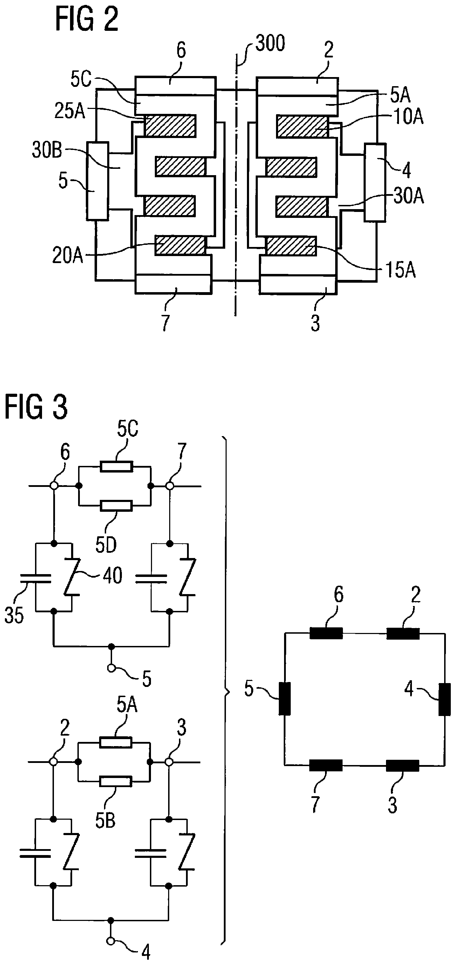

Zur Erzielung einer besonders hohen Integrationsdichte von Elektrodenstapeln im erfindungsgemäßen Bauelement ist es vorteilhaft, wenn die zumindest zwei Verschaltungsstrukturen zwei Elektrodenstapel miteinander verbinden, deren Kontaktflächen auf gegenüberliegenden Seitenflächen angeordnet sind und zumindest ein weiterer Elektrodenstapel mit den zwei Elektrodenstapeln überlappt, wobei dessen Kontaktfläche auf einer Stirnfläche des Grundkörpers angeordnet ist. Bei einer derartigen Anordnung von Elektrodenstapeln zueinander, wie sie beispielsweise in der Figur 2 in der Aufsicht gezeigt ist, ist es besonders leicht möglich, auf geringstem Raum zwei Vielschichtkondensatoren unterzubringen, die eine gemeinsame Kontaktfläche aufweisen.

Um ein erfindungsgemäßes elektrisches Bauteil mit breitbandiger Filterfunktion zur Unterdrückung von Rauschsignalen zu erhalten, bilden zwei überlappende Elektrodenstapel jeweils einen Vielschichtkondensator, wobei zwei Paare von jeweils einander gegenüberliegenden Vielschichtkondensatoren mit jeweils zwei Verschaltungsstrukturen zwei Π-Filter bilden. Eine besondere Ausführungsform eines derartigen Π-Filters ist beispielsweise in Figur 3 gezeigt, wobei dort die zwischen den Innenelektroden angeordneten keramischen Schichten eine Varistorkeramik, z.B. auf der Basis von ZnO-Bi und/oder ZnO-Pr enthalten. Möglich wäre aber auch, daß die keramischen Schichten nur eine Kondensatorkeramik enthalten, so daß eine Schaltungsanordnung ähnlich zu Figur 3 resultieren würde, bei der allerdings kein Varistoreffekt vorhanden wäre.

Im Falle von wenigstens zwei Verschaltungsstrukturen im oder auf dem Grundkörper wird ein erfindungsgemäßes Bauelement vorteilhafterweise so auf einem Substrat orientiert, daß wenigstens eine Verschaltungsstruktur zwischen dem Substrat und den Innenelektroden der Elektrodenstapel angeordnet ist, die von den Verschaltungsstrukturen verbunden sind. Eine derartige Anordnung aus einem erfindungsgemäßen elektrischen Bauelement und einem Substrat ist beispielsweise in Figur 7 gezeigt.

Im folgenden soll das erfindungsgemäße elektrische Bauelement anhand von Ausführungsbeispielen und Figuren noch näher erläutert werden. Bei den Figuren handelt es sich dabei um vereinfachte schematische Zeichnungen.
- Die Figuren 1A bis 1G: zeigen Aufsichten und einen Querschnitt eines erfindungsgemäßen elektrischen Bauelements.
- Die Figur 2: zeigt eine Aufsicht auf eine weitere Variante eines erfindungsgemäßen elektrischen Bauelements.
- Die Figur 3: zeigt ein Schaltbild eines erfindungsgemäßen elektrischen Bauelements.
- Die Figuren 4A bis 4C: zeigen verschiedene Ausführungsformen der Verschaltungsstrukturen in der Aufsicht und im Querschnitt.
- Figur 5: zeigt eine weitere Ausführungsform eines erfindungsgemäßen Bauelements im Querschnitt.
- Figur 6: zeigt eine andere Variante eines elektrischen Bauelements in der Aufsicht.
- Figur 7: zeigt im Querschnitt eine Anordnung aus einem erfindungsgemäßen elektrischen Bauelement und einer Platine.
- Die Figuren 8A und 8B: zeigen Meßdiagramme elektrischer Eigenschaften eines herkömmlichen und eines erfindungsgemäßen Bauelements.
- Figur 9: zeigt eine Schaltungsanordnung, bei der ein erfindungsgemäßes Bauelement zwischen einem Verstärker und einem störungsempfindlichen Gerät geschaltet ist.

Die Figuren 1A bis 1F zeigen in der Aufsicht verschiedene Schichten eines erfindungsgemäßen Bauelements, in denen Verschaltungsstrukturen bzw. Innenelektroden angeordnet sind. Diese Figuren zeigen dabei jeweils die Verschaltungsstruktur bzw. Innenelektroden, die in der jeweiligen Schicht angeordnet sind und zusätzlich aus Gründen der Anschaulichkeit und um die relative Anordnung der verschiedenen elektrischen Strukturen im Bauelement zu verdeutlichen, auch die Innenelektroden, die jeweils in darunterliegenden Schichten angeordnet sind. Zwischen Schichten, in denen Innenelektroden bzw. Verschaltungsstrukturen angeordnet sind, können jeweils beliebig viele keramische Schichten angeordnet sein, in denen keine Innenelektroden bzw. Verschaltungsstrukturen vorhanden sind. Die Figuren 1A bis 1F stellen dabei eine Abfolge der Schichten von oben nach unten im Grundkörper des Bauelements, beginnend mit Figur 1A und endend mit der Figur 1F. Diesen Figuren ist dabei zu entnehmen, daß eine Innenelektrode 30, die elektrisch leitend mit zwei äußeren Kontaktschichten 5 und 4 verbunden ist, mit vier Elektrodenstapeln überlappt, nämlich dem Elektrodenstapel 10, bestehend aus den Innenelektroden 10A und 10B, verbunden mit der äußeren Kontaktschicht 2, dem Elektrodenstapel 15, bestehend aus den Innenelektroden 15A und 15B in Kontakt mit der äußeren Kontaktschicht 3, dem Elektrodenstapel 20 aus den Innenelektroden 20A und 20B mit der äußeren Kontaktfläche 7 und dem Elektrodenstapel 25, der aus den Elektrodenschichten 25A, 25B und der Kontaktschicht 6 besteht. Die Elektrodenstapel 10 und 15 sind elektrisch leitend über zwei mäanderförmige Verschaltungsstrukturen 5A und 5B verbunden. Die anderen beiden Elektrodenstapel 25 und 20 sind ebenfalls über zwei mäanderförmige Verschaltungsstrukturen 5C und 5D miteinander verschaltet. Die mäanderförmigen Verschaltungsstrukturen weisen dabei eine besonders hohe Induktivität auf. Möglich sind aber auch anders ausgeformte Verschaltungsstrukturen, z.B. in der Form von Streifen. Dieses erfindungsgemäße Bauelement weist zwei Symmetrieebenen auf, eine Symmetrieebene 300 senkrecht zu den keramischen Schichten, die in allen Aufsichtsfiguren 1A bis 1 F eingezeichnet ist und eine parallel zu einer keramischen Schicht verlaufende Symmetrieebene 200, die in Figur 1G eingezeichnet ist. Diese beiden Symmetrieebenen bilden jeweils die Verschaltungsstrukturen und die Innenelektroden aufeinander ab.

Figur 1G zeigt einen Querschnitt, durch den in Figur 1A mit A bezeichneten Schnitt. Dabei ist zu erkennen, daß die Elektrodenstapel 10 und 15 zwischen den beiden die Elektrodenstapel verbindenden mäanderförmigen Verschaltungsstrukturen 5A und 5B angeordnet sind und die Symmetrieebene 200 z. B. die Verschaltungsstruktur 5A auf die Verschaltungsstruktur 5B und die Innenelektrode 15A auf die Innenelektrode 15B abbildet.

Figur 2 zeigt in der Aufsicht eine weitere Ausführungsform eines erfindungsgemäßen Bauelements, bei dem im Gegensatz zum in Figur 1A bis 1G gezeigten Bauelement die Elektrode 30 in zwei Elektroden 30A und 30B aufgeteilt ist, die jeweils nur mit zwei Elektrodenstapeln überlappen, so daß eine andere interne Verschaltung resultiert. Dabei sind nur die beiden obersten Verschaltungsstrukturen 5A und 5C gezeigt, aber nicht die jeweils dazu analogen Verschaltungsstrukturen im unteren Bereich des Bauelements.

Figur 3 zeigt ein Ersatzschaltbild des in der Figur 2 in der Aufsicht gezeigten elektrischen Bauelements. Unter Verwendung einer Varistorkeramik für die keramischen Schichten zwischen den Innenelektroden lassen sich die in Figur 3 gezeigten Π-Filter realisieren. Dabei resultiert jeweils eine Parallelschaltung eines Kondensatoreffekts 35 und eines Varistoreffekts 40, wobei zusätzlich aufgrund der zwei Verschaltungsstrukturen 5A, 5B bzw. 5C, 5D, die Parallelschaltung aus dem Kondensator- und Varistoreffekt miteinander verschaltet ist, wobei zusätzlich eine Parallelschaltung der Widerstände 5C und 5D bzw. 5A und 5B resultiert. Die Widerstände werden besonders vorteilhaft durch die z.B. in den Figuren 1A und 1F gezeigten mäanderförmigen Verschaltungsstrukturen realisiert. Möglich ist es aber auch, andere Formen für die Verschaltungsstrukturen, z.B. Streifen vorzusehen und diese aus einen Material auszubilden, daß einen hohen elektrischen Widerstand aufweist, z.B. RuO₂.

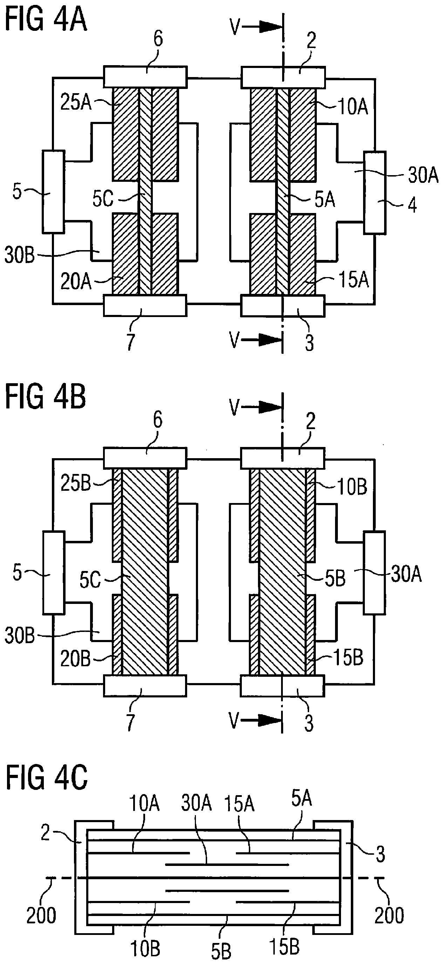

Die Figuren 4A und 4B zeigen Aufsichten auf weitere Varianten eines erfindungsgemäßen Bauelements, bei dem die Elektrodenstapel 10 und 15 von zwei verschieden ausgeformten Verschaltungsstrukturen 5A und 5B elektrisch leitend verbunden werden. In diesem Fall sind die Verschaltungsstrukturen als Streifen mit geradlinigem Verlauf ausgebildet, wobei die Verschaltungsstruktur 5A eine geringere Breite aufweist, als die Verschaltungsstruktur 5B.

Figur 4C zeigt einen Querschnitt durch den mit V in der Figur 4A bezeichneten Schnitt. Es ist zu erkennen, daß auch die streifenförmigen Verschaltungsstrukturen 5 A und 5B und z. B. die Innenelektroden 15A, 15B mittels einer Symmetrieebene 200 aufeinander abgebildet werden können.

Figur 5 zeigt eine andere Ausführungsform eines erfindungsgemäßen elektrischen Bauelements im Querschnitt, wobei die beiden Verschaltungsstrukturen 5A und 5B als Schichtbereiche auf gegenüberliegenden Oberflächen des Grundkörpers ausgebildet sind.

Figur 6 zeigt eine andere vorteilhafte Variante eines erfindungsgemäßen Bauelements in der Aufsicht auf die Verschaltungsstrukturen 5A und 5C. Dabei ist zu erkennen, daß diese Verschaltungsstrukturen 5A und 5C jeweils denjenigen Bereich abdecken, in dem die Elektrode 30A mit den Elektroden 15A und 10A bzw. die Elektrode 30B mit dem Elektroden 25A und 20A überlappt. Wenn wenigstens eine oder besser noch zwei Verschaltungsstrukturen in dieser Ausformung zwei Elektrodenstapel miteinander verbinden, lassen sich diese Elektrodenstapel besonders vorteilhaft gegenüber einer Platine abschirmen, auf die das Bauelement montiert werden kann. Dies hat zur Folge, daß der Einfluß der Bauteil-Lage auf die elektrischen Eigenschaften des Bauelements stark verringert wird.

Figur 7 zeigt eine vorteilhafte Anordnung aus einer Variante eines erfindungsgemäßen elektrischen Bauelements auf einem Substrat 100. Dabei ist zu erkennen, daß die Verschaltungsstruktur 5B zwischen dem Substrat, der Platine 100 und den Innenelektrodenstapeln 10 bzw. 15 angeordnet ist. Durch diese besondere Anordnung kommt eine besonders gute Abschirmung der Innenelektrodenstapel 10 und 15 gegenüber dem Substrat 100 zustande. Das erfindungsgemäße Bauelement 1 kann dabei um 180° um die Symmetrieebene 200 gedreht werden, wobei dann die Verschaltungsstruktur 5A zwischen der Platine 100 und den Innenelektrodenstapeln 10 und 15 angeordnet wäre. Auch bei einer derartigen um 180° rotierten Positionierung können bei einem erfindungsgemäßen elektrischen Bauelement ähnliche elektrische Eigenschaften erwartet werden wie bei der in Figur 7 gezeigten Anordnung.

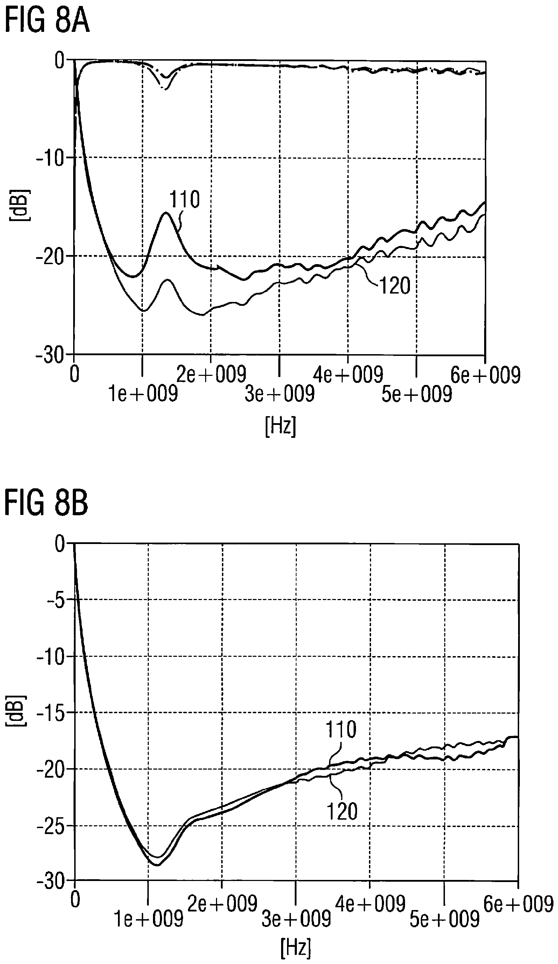

Figur 8A zeigt den Einfluß der Lage eines herkömmlichen Bauteils mit nur einer Verschaltungsstruktur und keinen Symmetrieebenen im Grundkörper relativ zu einer Platine auf das Dämpfungsverhalten des Bauteils. Das Bauteil ist dabei als Π-Filter ausgeführt. Die beiden mit 110 bzw. 120 bezeichneten Linien zeigen dabei das unterschiedliche Dämpfungsverhalten des Bauteils, wenn es um 180° um seine Längsachse gedreht und auf einer Platine montiert wird. Dabei ist zu erkennen, daß die um 180° unterschiedlichen Orientierungen des Bauteils einen großen Einfluß auf das Dämpfungsverhalten des herkömmlichen Π-Filters aufweisen.

Figur 8B zeigt das Dämpfungsverhalten eines erfindungsgemäßen Π-Filters, bei dem zwei Verschaltungsstrukturen zwei Elektrodenstapel intern miteinander verschalten und zusätzlich die beiden Symmetrieebenen vorhanden sind, wie z.B. in Fig. 1A bis 1G gezeigt. Die mit 110 bzw. 120 bezeichneten Linien geben dabei wieder das Dämpfungsverhalten bei zwei um 180° um die Längsachse rotierten Positionen des Bauteils auf der Platine an. Deutlich ist zu erkennen, daß die beiden unterschiedlichen Positionen bei erfindungsgemäßen Bauteilen nur einen geringen Einfluß auf das Dämpfungsverhalten zeigen.

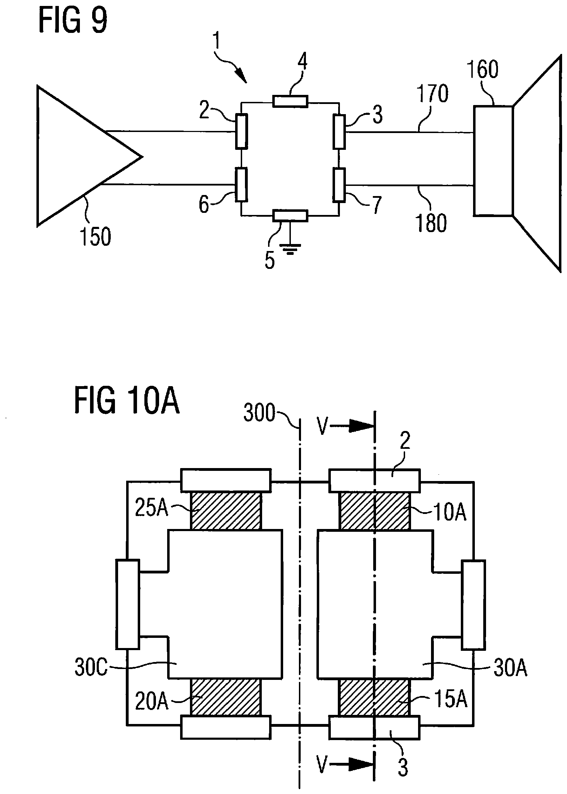

Figur 9 zeigt eine Schaltung, bei der ein erfindungsgemäßes elektrisches Bauelement 1 zwischen einen Verstärker 150 und einen störungsempfindlichen Gerät 160, beispielsweise einem Lautsprecher geschaltet ist. Der Verstärker 150 und das störungsempfindliche Gerät 160 sind über Zuleitungen 170, 180 verbunden, wobei zwischen die Zuleitungen das erfindungsgemäße Bauelement 1 geschaltet ist. Die äußeren Kontaktschichten 2, 3, 4, 5, 6 und 7 des erfindungsgemäßen elektrischen Bauelements beziehen sich dabei auf die in den Figuren 2 und 3 gezeigten äußeren Kontaktschichten. Die äußere Kontaktschicht 5 ist dabei mit der Erde verbunden. Sowohl hochfrequente Störungen, wie sie beispielsweise in Mobilfunkgeräten über die Trägerfrequenz von einigen 100 bis 10.000 MHz auftreten, als auch elektrostatische Entladungen, welche kurzzeitige Pulse mit hohen Spannungen generieren, können durch das Bauelement 1 sicher vor dem Gerät 160 zur Erde abgeleitet werden, wobei die Nutzsignale, im Beispiel aus Figur 9 Sprachsignale mit einigen KHz ungehindert vom Verstärker 150 zum Gerät 160 durchlaufen können.

Durch Verwenden eines geeigneten Keramikmaterials für die keramischen Schichten wird aus dem Vielschichtkondensator ein Vielschichtvaristor. Ebenso können durch Auswahl geeigneter Keramikmaterialien für die keramischen Schichten noch weitere Vielschichtbauelemente realisiert werden. Weitere Ausführungsbeispiele der Erfindung sind beispielsweise möglich hinsichtlich der Anzahl der durch Verschaltungsstrukturen miteinander verbundenen Elektrodenstapel möglich.

Im folgenden wird ein erfindungsgemäßes Bauelement beschrieben, das ebenfalls einen verringerten Einfluß der Positionierung des Bauteils auf die elektrischen Eigenschaften in einer äußeren Schaltungsumgebung, z.B. auf einer Platine zeigt. Ein solches erfindungsgemäßes Bauelement weist folgende Merkmale auf:
- ein Grundkörper der eine Abfolge von übereinandergestapelten keramischen Schichten umfaßt ist vorhanden,
- mehrere jeweils zwischen zwei keramischen Schichten angeordnete Innenelektroden sind vorhanden,
- auf der Oberfläche des Grundkörpers sind Kontaktflächen angeordnet, die elektrisch leitend mit den Innenelektroden verbunden sind, wobei Innenelektroden die mit der derselben Kontaktfläche verbunden sind einen Elektrodenstapel bilden,
- wenigstens eine Verschaltungsstruktur, die zwei Elektrodenstapel miteinander verbindet ist vorhanden,
- ein erster und ein zweiter Elektrodenstapel überlappen mit einem dritten Elektrodenstapel, wobei die Innenelektroden des ersten und zweiten Elektrodenstapels zwischen zwei Innenelektroden des dritten Elektrodenstapels angeordnet sind.

Ein derartiges Bauelement weist aufgrund der Abschirmung der Innenelektroden des ersten und zweiten Elektrodenstapels durch zwei Innenelektroden des dritten Elektrodenstapels ebenfalls einen verringerten Einfluß der Positionierung des Bauteils auf die elektrischen Eigenschaften in einer äußeren Schaltungsumgebung auf (siehe z.B. Fig. 10A bis 10C).

Vorteilhafterweise ist das Bauelement symmetrisch bezüglich der wenigstens einen Verschaltungsstruktur und Innenelektroden zu einer ersten Ebene und einer zweiten Ebene gebildet, wobei die erste Ebene parallel und die zweite Ebene senkrecht zu einer keramischen Schicht verläuft. Ein derartiges Bauelement weist zum einen aufgrund der Abschrirmung durch die Innenelektroden des dritten Elektrodenstapels und zum anderen aufgrund seiner hohen Symmetrie einen verringerten Einfluß der Positionierung des Bauteils auf die elektrischen Eigenschaften in einer äußeren Schaltungsumgebung auf.

Weiterhin ist es möglich, daß die wenigstens eine Verschaltungsstruktur als strukturierte Schicht auf den keramischen Schichten ausgebildet ist. Eine derartige Ausführungsform hat den Vorteil, daß die Verschaltungsstrukturen z.B. mittels Siebdruck besonders einfach auf den keramischen Schichten erzeugt werden können. Die Verschaltungsstrukturen können dabei aus leitfähigen Pasten erzeugt werden. Die Verschaltungsstrukturen können dabei ähnlich wie die Innenelektroden Silber, Palladium, Platin, Kupfer, Nickel oder eine Legierung aus Silber und Palladium oder aus Silber und Platin enthalten. Aus derartigen Metallen bzw. Metallegierungen hergestellte Verschaltungsstrukturen ermöglichen niederohmige Verschaltungen. Zur Generierung von hochohmigen Verschaltungsstrukturen ist es beispielsweise auch möglich, daß die Verschaltungsstrukturen RuO₂, Bi₂Ru₂O₇, C, Ti₂N oder LaB₆ enthalten.

Vorteilhafterweise können wenigstens zwei Verschaltungsstrukturen vorhanden sein, die zwei Elektrodenstapel miteinander verbinden, so daß eine interne Verschaltung resultiert.

Weiterhin können eine erste und zweite Verschaltungsstruktur vorhanden sein, die so ausgeformt sind, daß sie von oben oder unten betrachtet zumindest den Bereich in dem die zwei Elektrodenstapel mit dem dritten Elektrodenstapel überlappen, abdeckt. In diesem Fall resultiert besonders vorteilhaft eine doppelte Abschirmung der Innenelektroden des ersten und zweiten Elektrodenstapels durch die Innenelektroden des dritten Elektrodenstapels und der Verschaltungsstrukturen.

Fig. 10A bis 10C zeigen ein erfindungsgemäßes Bauelement im Querschnitt und in der Aufsicht.

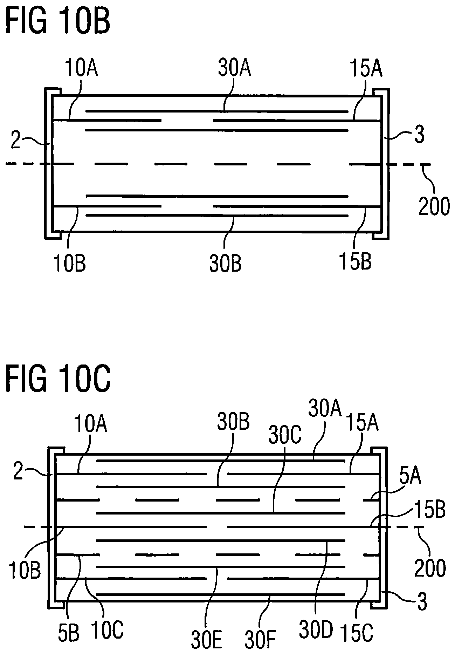

Fig. 10A zeigt in der Aufsicht zwei Innenelektroden 30A, 30C von zwei dritten Elektrodenstapeln, die jeweils mit den Innenelektroden 10A, 15A bzw. 20A, 25 A von ersten und zweiten Elektrodenstapeln überlappen. Die Fig. 10B und 10C zeigen jeweils Querschnitte durch zwei unterschiedliche Varianten des Bauelements durch den mit V in Fig. 10A bezeichneten Schnitt. Beide Varianten weisen die in der Fig. 10A gezeigte Aufsicht auf und unterscheiden sich in der Anzahl der Verschaltungsstrukturen 5A, 5B, sowie der Anzahl der Innenelektroden je Elektrodenstapel wie in den Querschnitten zu erkennen ist. Es ist zu sehen, daß in Fig. 10B zwei Innenelektroden 30A, 30B eines dritten Elektrodenstapels so angeordnet sind, daß die Innenelektroden 15A, 15B und 10A, 10B zwischen ihnen angeordnet sind. Zusätzlich ist eine Verschaltungsstruktur 5A vorhanden, die in der Mitte zwischen beiden Innenelektroden 30A, 30B positioniert ist. Fig. 10C zeigt eine größere Anzahl von Innenelektroden je Elektrodenstapel, wobei zusätzlich zwei Verschaltungsstrukturen 5A, 5B vorhanden sind und die Verschaltungsstrukturen sowie die Innenelektroden des Elektrodenstapels 10, 10A, 10B, 10C und die Innenelektroden des Elektrodenstapels 15, 15A, 15B, 15C zwischen den zwei äußersten Innenelektroden 30A, 30F des dritten Elektrodenstapels angeordnet sind. Beide Varianten weisen darüber hinaus auch die Symmetrieebenen 200 und 300 auf.

Im übrigen können alle gezeigten Merkmale eines erfindungsgemäßen Bauelements in beliebiger Kombination realisiert werden.

## Patentansprüche

1. Elektrisches Bauelement mit den Merkmalen:
- ein Grundkörper (1) der eine Abfolge von übereinandergestapelten keramischen Schichten umfaßt ist vorhanden,
- mehrere jeweils zwischen zwei keramischen Schichten angeordnete Innenelektroden (10A, 10B, 15A, 15B) sind vorhanden,
- auf der Oberfläche des Grundkörpers sind Kontaktflächen (2, 3) angeordnet, die elektrisch leitend mit den Innenelektroden (10A, 10B, 15A, 15B) verbunden sind, wobei Innenelektroden die mit derselben Kontaktfläche verbunden sind einen Elektrodenstapel (10, 15) bilden,
- wenigstens eine Verschaltungsstruktur (5A), die zwei Elektrodenstapel (10, 15) miteinander verbindet ist vorhanden, wobei die wenigstens eine Verschaltungsstruktur (5A) zwei Kontaktflächen (2, 3) der Elektrodenstapel direkt miteinander verbindet
- ein erster und ein zweiter Elektrodenstapel überlappen mit einem dritten Elektrodenstapel, wobei die Innenelektroden des ersten und zweiten Elektrodenstapels zwischen zwei Innenelektroden des dritten Elektrodenstapels angeordnet sind
**dadurch gekennzeichnet, dass**
die wenigstens eine Verschaltungsstruktur aus einem Material ausgebildet ist, das einen höheren elektrischen Widerstand als die Innenelektroden aufweist und
- das Bauelement ist symmetrisch bezüglich der wenigstens einen Verschaltungsstruktur und Innenelektroden zu einer ersten Ebene (200) und einer zweiten Ebene (300) gebildet, wobei die erste Ebene parallel und die zweite Ebene senkrecht zu einer keramischen Schicht verläuft.

2. Bauelement nach Anspruch 1,
- bei dem der Grundkörper entlang einer Längsrichtung verlaufende Seitenflächen und mindestens eine Stirnfläche aufweist,
- bei dem durch zwei überlappende Elektrodenstapel ein Vielschichtkondensator gebildet ist,
- wobei die Kontaktfläche eines überlappenden Elektrodenstapels des Vielschichtkondensator auf einer Seitenfläche und die Kontaktfläche des anderen überlappenden Elektrodenstapels des Vielschichtkondensators auf der Stirnfläche des Grundkörpers angeordnet ist.

3. Bauelement nach einem der vorhergehenden Ansprüche,
- bei dem wenigstens zwei Verschaltungsstrukturen vorhanden sind, die zwei Elektrodenstapel miteinander verbinden.

4. Bauelement nach einem der vorhergehenden Ansprüche,
- bei dem durch jeweils zwei überlappende Elektrodenstapel ein Vielschichtkondensator gebildet ist,
- bei dem zwei Paare von jeweils einander gegenüberliegen Vielschichtkondensatoren mit jeweils zwei Verschaltungsstrukturen zwei Π-Filter bilden.

5. Bauelement nach Anspruch 4,
- bei dem die zwischen den Innenelektroden (10A, 10B, 15A, 15B) angeordneten keramischen Schichten eine Varistorkeramik enthalten.

6. Bauelement nach Anspruch 4,
- bei dem die zwischen den Innenelektroden (10A, 10B, 15A, 15B) angeordneten keramischen Schichten eine Kondensatorkeramik enthalten.

7. Bauelement nach einem der vorhergehenden Ansprüche,
- bei dem eine erste und zweite Verschaltungsstruktur (5A, 5B) vorhanden sind, die so ausgeformt sind, daß sie von oben oder unten betrachtet zumindest den Bereich, in dem die zwei Elektrodenstapel (10, 15) mit dem dritten Elektrodenstapel (30) überlappen, abdeckt.

8. Anordnung aufweisend,
- ein Bauelement gemäß einem der Ansprüche 4 bis 7 und
- ein Substrat,
- wobei das Bauelement so auf dem Substrat orientiert ist, dass zumindest eine der wenigstens zwei Verschaltungsstrukturen zwischen dem Substrat und den Innenelektroden (10A, 10B, 15A, 15B) der Elektrodenstapel angeordnet ist, die von den wenigstens zwei Verschaltungsstrukturen verbunden sind.

## Claims

1. Electrical component with the features that:
- there is a base body (1), which comprises a sequence of ceramic layers stacked one on top of the other,
- there are a number of inner electrodes (10A, 10B, 15A, 15B), respectively arranged between two ceramic layers,
- arranged on the surface of the base body are contact areas (2, 3), which are connected in an electrically conducting manner to the inner electrodes (10A, 10B, 15A, 15B), inner electrodes that are connected to the same contact area forming an electrode stack (10, 15),
there is at least one interconnection structure (5A), which interconnects two electrode stacks (10, 15),wherein the at least one interconnection structure (5A) directly interconnects two contact areas (2, 3) of the electrode stacks,
a first and a second electrode stack overlap with a third electrode stack, wherein the inner electrodes of the first and second electrode stacks are arranged between two inner electrodes of the third electrode stack,
**characterized in that**
the at least one interconnection structure is formed from a material that has a higher electrical resistance than the inner electrodes and
- the component is formed symmetrically with respect to the at least one interconnection structure and inner electrodes in relation to a first plane (200) and a second plane (300), the first plane running parallel and the second plane running perpendicular to a ceramic layer.

2. Component according to Claim 1,
- in which the base body has side faces running along a longitudinal direction and at least one end face,
- in which a multilayer capacitor is formed by two overlapping electrode stacks,
- the contact area of one overlapping electrode stack of the multilayer capacitor being arranged on one side face and the contact area of the other overlapping electrode stack of the multilayer capacitor being arranged on the end face of the base body.

3. Component according to either of the preceding claims,
- in which there are at least two interconnection structures, which interconnect two electrode stacks.

4. Component according to one of the preceding claims,
- in which a multilayer capacitor is formed by in each case two overlapping electrode stacks,
- in which two pairs of multilayer capacitors respectively lying opposite each other, together with in each case two interconnection structures, form two Π-filters.

5. Component according to Claim 4,
- in which the ceramic layers arranged between the inner electrodes (10A, 10B, 15A, 15B) comprise a varistor ceramic.

6. Component according to Claim 4,
- in which the ceramic layers arranged between the inner electrodes (10A, 10B, 15A, 15B) comprise a capacitor ceramic.

7. Component according to one of the preceding claims,
- in which there are a first and second interconnection structures (5A, 5B), which are formed such that, seen from above or below, they cover at least the region in which the two electrode stacks (10, 15) overlap with the third electrode stack (30).

8. Arrangement, having
- a component according to one of Claims 4 to 7 and
- a substrate,
- wherein the component is oriented on the substrate such that at least one of the at least two interconnection structures is arranged between the substrate and the inner electrodes (10A, 10B, 15A, 15B) of the electrode stacks that are connected by the at least two interconnection structures.

## Revendications

1. Composant électrique qui présente les caractéristiques suivantes :
il est prévu un corps de base (1) qui comporte une succession de couches céramiques empilées les unes au-dessus des autres,
il est prévu plusieurs électrodes intérieures (10A, 10B, 15A, 15B) disposées à chaque fois entre deux couches céramiques,
des surfaces de contact (2, 3) qui sont reliées de manière électriquement conductrice aux électrodes intérieures (10A, 10B, 15A, 15B) sont disposées sur la surface du corps de base, les électrodes intérieures reliées à une même surface de contact formant une pile d'électrodes (10, 15),
il est prévu au moins une structure de raccordement (5A) qui relie l'une à l'autre deux piles d'électrodes (10, 15), l'au moins une structure de raccordement (5A) reliant l'une à l'autre directement deux surfaces de contact (2, 3) de la pile d'électrodes,
une première et une deuxième pile d'électrodes étant superposées à une troisième pile d'électrodes, les électrodes intérieures de la première et de la deuxième pile d'électrodes étant disposées entre deux électrodes intérieures de la troisième pile d'électrodes,
**caractérisé en ce que**
l'au moins une structure de raccordement est réalisée en un matériau qui présente une résistance électrique supérieure aux électrodes intérieures et
le composant électrique est formé symétriquement par rapport à l'au moins une structure de raccordement et aux électrodes intérieures par rapport à un premier plan (200) et un deuxième plan (300), le premier plan s'étendant parallèlement à une couche céramique et le deuxième plan s'étendant perpendiculairement à celle-ci.

2. Composant selon la revendication 1,
dans lequel le corps de base présente des surfaces latérales qui s'étendent dans le sens de la longueur et au moins une surface frontale,
dans lequel un condensateur multicouche est formé par deux piles d'électrodes superposées,
la surface de contact d'une pile d'électrodes superposée du condensateur multicouche étant disposée sur une surface latérale du corps de base et la surface de contact de l'autre pile d'électrodes superposée du condensateur multicouche étant disposée sur la surface frontale du corps de base.

3. Composant selon l'une des revendications précédentes,
qui présente au moins deux structures de raccordement qui relient l'une à l'autre deux piles d'électrodes.

4. Composant selon l'une des revendications précédentes,
dans lequel un condensateur multicouche est formé chaque fois par deux piles d'électrodes superposées,
dans lequel deux paires de condensateurs multicouches situées l'un en face de l'autre et présentant chacune 2 structures de raccordement forment deux filtres Π.

5. Composant selon la revendication 4,
dans lequel les couches céramiques disposées entre les électrodes intérieures (10A, 10B, 15A, 15B) contiennent une varistance en céramique.

6. Composant selon la revendication 4,
dans lequel les couches céramiques disposées entre les électrodes intérieures (10A, 10B, 15A, 15B) contiennent un condensateur en céramique.

7. Composant selon l'une des revendications précédentes,
qui présente une première et une deuxième structure de raccordement (5A, 5B) qui sont façonnées de telle sorte que vues du haut ou du bas, elles recouvrent au moins la partie dans laquelle les deux piles d'électrodes (10, 15) sont superposées à la troisième pile d'électrodes (30).

8. Agencement présentant
un composant selon l'une quelconque des revendications 4 à 7, et
un substrat,
le composant étant orienté sur le substrat de telle sorte qu'au moins l'une des au moins deux structures de raccordement soit disposée entre le substrat et les électrodes intérieures (10A, 10B, 15A, 15B) de la pile d'électrodes qui sont connectées par les au moins deux structures de raccordement.
